# EUROPEAN PATENT APPLICATION

(11) **EP 4 787 420 A1**
(43) Date of publication of application: **05.08.2026**
(21) Application number: 24887727.6
(22) Date of filing: 18.10.2024
(51) Int. Cl.: H01J 37/32

(54) **ANNULAR LINING APPARATUS, LINER, PROCESS CHAMBER, AND SEMICONDUCTOR PROCESS DEVICE**

(30) Priority: 08.11.2023 CN 202311484943
(71) Applicant: Beijing NAURA Microelectronics Equipment Co., Ltd., Beijing 100176 (CN)
(72) Inventor: FAN, Yingxu, Beijing 100176 (CN); TANG, Xiwen, Beijing 100176 (CN); WANG, Fulai, Beijing 100176 (CN); SUN, Baolin, Beijing 100176 (CN)
(74) Representative: Cohausz & Florack
(86) International application number: PCT/CN2024/125653
(87) International publication number: WO 2025/098114

(57) **Abstract**

The present disclosure discloses an annular liner apparatus, a liner, a process chamber, and semiconductor process equipment. The annular liner apparatus is used in a process chamber and includes a first annular liner, a cylindrical liner, and a second annular liner. The first annular liner is connected to a first end of the cylindrical liner, and the second annular liner is connected to a second end of the cylindrical liner. The cylindrical liner is expandable and retractable along the axial direction of the cylindrical liner. This solution addresses the problem of poor shielding caused by poor grounding connection in the liner of the process chamber in related technologies.

## Description

### TECHNICAL FIELD

The present disclosure generally relates to the technical field of semiconductor process equipment and, more particularly, to an annular liner apparatus, a liner, a process chamber, and semiconductor process equipment.

### BACKGROUND

During semiconductor processing, to ensure process effectiveness and prevent plasma leakage within the process space, the process chamber in related technologies is equipped with a liner. The liner achieves radio frequency shielding through grounding, thereby preventing plasma leakage. However, the liner in related technologies suffers from poor grounding, ultimately failing to achieve adequate shielding and resulting in significant plasma escape.

### SUMMARY

The present disclosure discloses an annular liner apparatus, a liner, a process chamber, and semiconductor process equipment to solve the problem of poor shielding caused by poor grounding of the liner in the process chamber in related technologies.

To address the aforementioned technical problems, the present disclosure provides the following technical solutions:

In a first aspect, embodiments of the present disclosure disclose an annular liner apparatus for a process chamber. The annular liner apparatus includes a first annular liner, a cylindrical liner, and a second annular liner, where:

The first annular liner is connected to a first end of the cylindrical liner, and the second annular liner is connected to a second end of the cylindrical liner. The cylindrical liner is extendable and retractable in the axial direction of the cylindrical liner.

In a second aspect, embodiments of the present disclosure disclose a liner for a process chamber. The disclosed liner includes a third annular liner and the aforementioned annular liner apparatus. The second annular liner can be in pressing engagement with the third annular liner of the annular liner apparatus.

In a third aspect, embodiments of the present disclosure disclose a process chamber. The disclosed process chamber includes a chamber, a carrier, and the aforementioned liner. The chamber has a transfer port, and the third annular liner is disposed around the carrier.

In the process state, the second annular liner presses against the third annular liner.

In the non-process state, the second annular liner separates from the third annular liner, and the cylindrical liner shortens and avoids the transfer port.

In a fourth aspect, the present disclosure discloses semiconductor process equipment including the process chamber described above.

The technical solution in the present disclosure achieves the following technical effects:

The annular liner apparatus disclosed in the present disclosure, since the cylindrical liner connected between the first annular liner and second annular liner is expandable and retractable, can change the distance between the first annular liner and second annular liner through expansion and retraction. This allows the cylindrical liner to adjust the position of the second annular liner by expanding and contracting while the first annular liner is in tight electrical contact with the mating first component. This enables the second annular liner to adaptively locate and achieve tight electrical contact with the mating second component. Furthermore, the first annular liner and second annular liner can each independently achieve tight electrical contact with the first component and the second component without creating gaps between the first component and the second component that would affect the grounding connection. Ultimately, the first component is electrically connected to the second component sequentially through the first annular liner, the cylindrical liner, and the second annular liner, achieving a relatively stable grounding connection.

This type of annular liner apparatus offers flexible positional adaptability, ensuring good electrical contact between the electrically contacting components. In other words, the position of the first annular liner does not restrict the position of the second annular liner, preventing the second annular liner from achieving proper pressing electrical contact with the second component. This avoids gaps between the second annular liner and the second component that could lead to poor electrical contact, thus mitigating the resulting poor grounding and preventing inadequate shielding due to poor grounding.

### BRIEF DESCRIPTION OF THE DRAWINGS

FIG. 1 is a structural schematic diagram of the process chamber disclosed in the embodiments of the present disclosure;
FIG. 2 is an exploded view of the structure of a part of the process chamber disclosed in the embodiments of the present disclosure;
FIG. 3 is a structural schematic diagram of FIG. 2 in an assembled state;
FIG. 4 is a sectional view of a part of FIG. 3 from another perspective;
FIG. 5 is a sectional view of the pressing mechanism disclosed in the embodiments of the present disclosure;
FIG. 6 is an enlarged view of a part of the structure in FIG. 1;
FIG. 7 is an enlarged view of a part of the structure in FIG. 6;
FIG. 8 is a structural schematic diagram of the process chamber disclosed in the embodiments of the present disclosure in a non-process state;
FIG. 9 is a structural schematic diagram of the process chamber disclosed in the embodiments of the present disclosure in a process state.

### Reference numerals:

01 - Third annular liner, 011 - Second bent surface, 012 - Second annular positioning groove,
02 - Carrier,
03 - Distribution plate, 031 - Edge, 0311 - First annular positioning groove,
04 - First annular liner, 041 - Annular edge, 042 - First mounting hole, 043 - First sleeve, 044 - Annular body, 045 - Liner cylinder,
05 - Cylindrical liner, 051 - Clearance window, 052 - First ring, 053 - Second ring, 054 - Inner bellows, 055 - Outer bellows,
06 - Second annular liner, 061 - First bent surface, 062 - Connection groove, 063 - Hooking protrusion,
07 - Guide rod,
08 - Chamber body, 081 - Wafer transfer port, 082 - Through hole,
09 - First induction coil,
10 - Second induction coil,
11 - Pressing mechanism, 111 - Cylindrical housing, 112 - First sliding member, 1121 - Sliding sleeve, 1122 - Guide block, 1123 - Connection block, 1124 - Third annular flange, 1125 - Second mounting hole, 1126 - First shaft sleeve, 1127 - Seventh annular flange,
113 - Second sliding member, 1131 - First rod body, 1132 - First annular flange, 1133 - Second rod body, 1134 - Second annular flange, 1135 - Sixth annular flange, 114 - Elastic member, 115 - First telescopic cylinder, 116 - Fourth annular flange, 117 - Second telescopic cylinder, 118 - Second shaft sleeve, 119 - Fifth annular flange, 120 - Mounting base,
12 - Clamping piece, 13 - Washer, 14 - Power source, 15 - Connection rod,
101 - Second guide hole, 102 - First guide hole, A - First gap, B - Second gap, C - Third gap, D - Process space, E - Internal space.

### DETAILED DESCRIPTION OF THE EMBODIMENTS

To make the objectives, technical solutions, and advantages of the present disclosure clearer, the technical solutions of the present disclosure will be clearly and completely described below in conjunction with specific embodiments and corresponding drawings. Obviously, the described embodiments are only a part of the embodiments of the present disclosure, and not all of the embodiments. Based on the embodiments in the present disclosure, all other embodiments obtained by those skilled in the art without creative effort are within the scope of protection of the present disclosure.

In the process chamber in related technologies, the process chamber includes a liner and a lifting mechanism. The liner may include an annular liner and a bottom liner. The lifting mechanism is connected to the annular liner, thereby realizing the overall lifting and lowering of the annular liner. After being raised, the annular liner can avoid the wafer transfer port of the process chamber, thus enabling the wafer to enter and exit through the wafer transfer port. After the annular liner is lowered, the annular liner will make electrical contact with the corresponding first component and second component respectively. The first component may be, for example, a distribution plate for distributing gas, and the second component may be, for example, the bottom liner. In the process of realizing the present disclosure, the inventors discovered that after the grounding electrical contact between the liner and one of the first component and the second component is ensured, there is often a large gap between the liner and the other of the first component and the second component, preventing the formation of a conductive path between the liner and the other of the first component and the second component, seriously affecting the radio frequency shielding performance of the liner.

To solve this problem, the inventors of the present disclosure designed a technical solution and proposed the technical solutions in the embodiments of the present disclosure. The technical solutions disclosed in the various embodiments of the present disclosure are described in detail below with reference to the accompanying drawings.

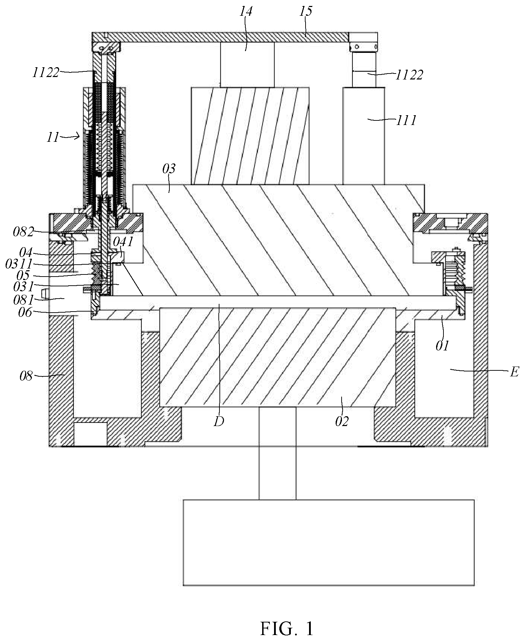

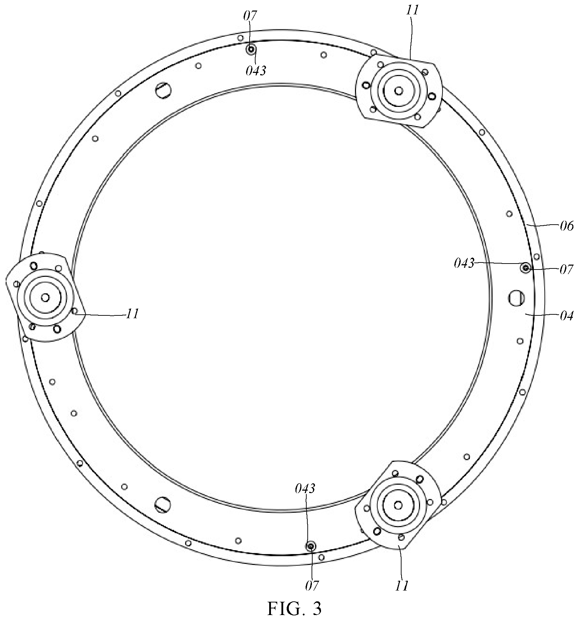

As shown in FIGs. 1 to 7, embodiments of the present disclosure disclose an annular liner apparatus. The disclosed annular liner apparatus is used in a process chamber. The disclosed annular liner apparatus includes a first annular liner 04, a cylindrical liner 05, and a second annular liner 06. The first annular liner 04 is connected to a first end of the cylindrical liner 05. The second annular liner 06 is connected to a second end of the cylindrical liner 05. Specifically, the first annular liner 04 and the first end of the cylindrical liner 05, and the second annular liner 06 and the second end of the cylindrical liner 05, can be fixedly connected by means of adhesive bonding, snap-fitting, or connection via connecting members.

The cylindrical liner 05 can be extendable and retractable in the axial direction of the cylindrical liner. It should be noted that the axial direction refers to the direction in which the axis of the cylindrical liner 05 extends along the through direction of the cylindrical cavity. The extendable and retractable nature of the cylindrical liner 05 in the axial direction allows for adjustment of the length of the cylindrical liner 05, and, adjustment of the distance between the first annular liner 04 and the second annular liner 06. Specifically, if the distance between the first annular liner 04 and the second annular liner 06 increases, the cylindrical liner 05 elongates; if the distance between the first annular liner 04 and the second annular liner 06 decreases, the cylindrical liner 05 shortens. Of course, elongating the cylindrical liner 05 increases the distance between the first annular liner 04 and the second annular liner 06. Shortening the cylindrical liner 05 decreases the distance between the first annular liner 04 and the second annular liner 06.

Consistent with the present disclosure, the inner edge of the first annular liner 04 protrudes from the inner wall of the cylindrical liner 05, forming an annular edge 041. The annular edge 041 at least serves a pressing function.

The annular liner apparatus disclosed in the present disclosure, since the cylindrical liner 05 connected between the first annular liner 04 and the second annular liner 06 can be extendable and retractable, the distance between the first annular liner 04 and the second annular liner 06 can be changed by extending and retracting the cylindrical liner 05. This allows the cylindrical liner 05 to adjust the position of the second annular liner 06 through expansion and retraction while the first annular liner 04 is in tight electrical contact with the mating first component (e.g., the distribution plate 03), thereby enabling the second annular liner 06 to adaptively locate and make tight electrical contact with the mating second component (e.g., the third annular liner 01). This enables the first annular liner 04 and the second annular liner 06 to independently make tight electrical contact with the first component and the second component, respectively, without creating gaps between the first component or the second component that would affect the grounding connection. Ultimately, the first component is electrically connected to the second component sequentially through the first annular liner 04, the cylindrical liner 05, and the second annular liner 06, achieving a relatively stable electrical connection, such as stable grounding.

This type of annular liner apparatus offers flexible positional adaptability, ensuring good electrical contact between the electrically contacting components. Specifically, the position of the first annular liner 04 does not restrict the position of the second annular liner 06, preventing second annular liner 06 from achieving proper pressing contact with the second component. This avoids gaps between the second annular liner 06 and the second component that can lead to poor electrical contact. Thus, in turn, mitigates the resulting poor grounding and ultimately prevents poor shielding due to inadequate grounding.

Consistent with the present disclosure, the inner edge of the first annular liner 04 protrudes from the inner wall of the cylindrical liner 05, forming an annular edge 041. This allows the first annular liner 04 to achieve electrical connection with the first component through pressing electrical contact via the annular edge 041.

As mentioned above, the cylindrical liner 05 is expandable and retractable, allowing the distance between the first annular liner 04 and the second annular liner 06 to change. To improve the extension and retraction capability and better ensure that the relative movement between the first annular liner 04 and the second annular liner 06 is along the axial direction of the cylindrical liner 05, in some embodiments, the annular liner apparatus disclosed in the present disclosure may further include a guide rod 07. The guide rod 07 performs a guiding function. The first end of the guide rod 07 is fixedly connected to one of the first annular liner 04 and the second annular liner 06, and the second end of the guide rod 07 passes through the side wall of the cylindrical liner 05 and is at least extending through the other of the first annular liner 04 and the second annular liner 06, thus slidingly engaging with the other of the first annular liner 04 and the second annular liner 06 (i.e., the first annular liner 04 or the second annular liner 06). The guide rod 07, through sliding engagement with the first annular liner 04 or the second annular liner 06, guides the alignment of the first annular liner 04 and the second annular liner 06. Under the guiding action of the guide rod 07, the relative movement between the first annular liner 04 and the second annular liner 06 can be well carried out along the axial direction of the cylindrical liner 05. It should be noted that the guide rod 07 is parallel to the axial direction of the cylindrical liner 05.

As mentioned above, the guide rod 07 can be fixed to the first annular liner 04 and simultaneously slidably engaged with the second annular liner 06. Or, the guide rod 07 can be fixed to the second annular liner 06 and simultaneously slidably engaged with the first annular liner 04. The present disclosure does not limit on this.

To alleviate wear on the first annular liner 04 or the second annular liner 06 that is slidably engaged with the guide rod 07, in some embodiments, the first annular liner 04 or the second annular liner 06 is provided with a first mounting hole 042, and a first sleeve 043 is fixedly installed in the first mounting hole 042. The guide rod 07 passes through the first sleeve 043 and is slidably engaged with the first sleeve 043. In this case, the first sleeve 043 serves to slide-contact with the guide rod 07, thereby preventing the guide rod 07 from directly contacting the first annular liner 04 or the second annular liner 06 and causing wear on the first annular liner 04 or the second annular liner 06.

In some embodiments, the number of guide rods 07 can be one or more, and the specific number of guide rods 07 is not limited in the present disclosure. In embodiments with multiple guide rods 07, the multiple guide rods 07 can be spaced apart in the circumferential direction of the annular liner apparatus, thereby providing a more balanced guiding effect in the circumferential direction of the annular liner apparatus.

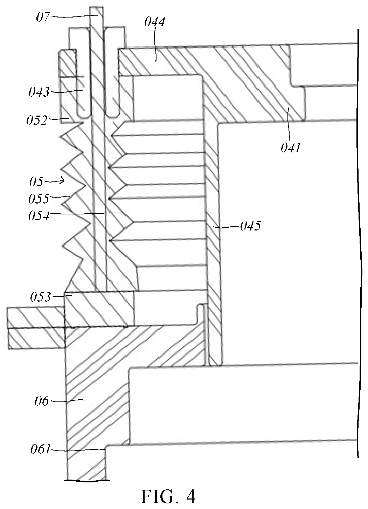

As mentioned above, the cylindrical liner 05 can be extendable and retractable, thereby the length of the cylindrical liner 05 can be changed. The structure of the cylindrical liner 05 can be various. For example, the cylindrical liner 05 can be a cylindrical component made of a flexible material. The cylindrical liner 05 can also be designed as an extendable and retractable structure; for example, the cylindrical liner 05 can be a structure similar to a bellows shape. Based on this, as shown in FIGs. 4 to 7, in some embodiments, the cylindrical liner 05 may include a first ring 052, a second ring 053, an inner bellows 054, and an outer bellows 055. The inner bellows 054 is disposed inside the outer bellows 055, and an annular gap is formed between the inner bellows 054 and the outer bellows 055. The first ring 052 is sealed at a first end of the annular gap, and the second ring 053 is sealed at a second end of the annular gap. The first ring 052 is connected to one of the first annular liner 04 and the second annular liner 06. The second ring 053 is connected to the other of the first annular liner 04 and the second annular liner 06. During the expansion and retraction process, the distance between the first annular liner 04 and the second annular liner 06 decreases, which in turn reduces the distance between the first ring 052 and the second ring 053, thus shortening the inner bellows 054 and the outer bellows 055. Or, the distance between the first annular liner 04 and the second annular liner 06 increases, which in turn increases the distance between the first ring 052 and the second ring 053, thus extending the inner bellows 054 and the outer bellows 055. In this structure, the cylindrical liner 05 works synergistically through the inner bellows 054 and the outer bellows 055 to achieve the expansion and retraction function. Simultaneously, the first ring 052 and the second ring 053 facilitate the connection of the first annular liner 04 and the second annular liner 06 to the cylindrical liner 05, respectively.

Specifically, the first ring 052 and the first annular liner 04 or the second annular liner 06, and the second ring 053 and the first annular liner 04 or the second annular liner 06, can be connected by means of snap-fit, adhesive bonding, or connector connection. The present disclosure does not limit the specific connection method between the first ring 052 and the first annular liner 04 or the second annular liner 06, and between the second ring 053 and the first annular liner 04 or the second annular liner 06.

In the case of annular liner apparatus disclosed in the present disclosure includes a guide rod 07, the guide rod 07 passes through the sidewall of cylindrical liner 05. That is, a part of the structure of guide rod 07 extends through the sidewall of cylindrical liner 05, without causing damage to the sidewall of cylindrical liner 05 that could lead to plasma escape. When cylindrical liner 05 includes a first ring 052, a second ring 053, an inner bellows 054, and an outer bellows 055, a part of guide rod 07 is located within the aforementioned annular gap. The first end of guide rod 07 passes through one of the first ring 052 and the second ring 053 and is fixedly connected to the first annular liner 04 or the second annular liner 06. The second end of guide rod 07 passes through the other of the first ring 052 and the second ring 053 and is in sliding engagement with the first annular liner 04 or the second annular liner 06. This structure of cylindrical liner 05 can form an annular gap that allows the guide rod 07 to pass through, facilitating the assembly of the guide rod 07 and reducing the likelihood of the guide rod 07 piercing the sidewall of cylindrical liner 05 during assembly.

Consistent with the present disclosure, the first annular liner 04 may include an annular body 044. The annular body 044 may be an annular sheet, and an annular edge 041 is formed at the inner edge of the annular body 044. In another embodiment, the first annular liner 04 may further include a liner cylinder 045 in addition to the annular body 044. The inner edge of the annular body 044 protrudes from the inner wall of the liner cylinder 045 and forms the annular edge 041. A first port of the liner cylinder 045 is sealed to the surface of the annular body 044 facing towards the second annular liner 06. Specifically, the first port of the liner cylinder 045 and the surface of the annular body 044 can be bonded together with sealant. Of course, the liner cylinder 045 and the annular body 044 can be an integral structure, i.e., manufactured using a one-piece molding process. The second port of the liner cylinder 045 is disposed adjacent to the second annular liner 06, and at least a part of the liner cylinder 045 is disposed inside the cylindrical liner 05. In this case, the liner cylinder 045 is located inside the cylindrical liner 05, thereby assisting the cylindrical liner 05 in achieving double protection.

In some embodiments, at least one of the annular edge 041 or the edge of the first component (e.g., the distribution plate 03) is provided with a first annular positioning groove 0311 for mounting the first induction coil 09. Consistent with the present disclosure, the first annular positioning groove 0311 is provided at the surface of the edge 031 of the distribution plate 03 facing towards the annular edge 041. However, the embodiments of the present disclosure are not limited to this. In practical applications, the first annular positioning groove 0311 may also be provided at the surface of the annular edge 041 facing towards the second annular liner 06. Further, the first annular positioning grooves 0311 can be formed at the surfaces of the annular edge 041 and the first component (e.g., the distribution plate 03) that face each other. In this case, the first induction coil 09 can be disposed in both of the two first annular positioning grooves 0311, or two first induction coils 09 can be disposed in each of the two first annular positioning grooves 0311, and the two first induction coils 09 are in electrical contact.

In some embodiments, at least one of the second annular liner 06 or the second component (e.g., the third annular liner 01) is provided with a second annular positioning groove 012 for mounting the second induction coil 10. Consistent with the present disclosure, the second annular positioning groove 012 is provided at the surface of the third annular liner 01 facing towards the edge of the second annular liner 06. However, the embodiments of the present disclosure are not limited to this. In practical applications, a second annular positioning groove 012 can also be provided at the edge of the second annular liner 06. In some embodiments, the second annular positioning grooves 012 can be formed at the surfaces of the second annular liner 06 and the second component (e.g., the third annular liner 01) that faces each other. In this case, the second induction coil 10 can be disposed in these two second annular positioning grooves 012, or two second induction coils 10 can be disposed in each of the two second annular positioning grooves 012, and the two second induction coils 10 are in electrical contact.

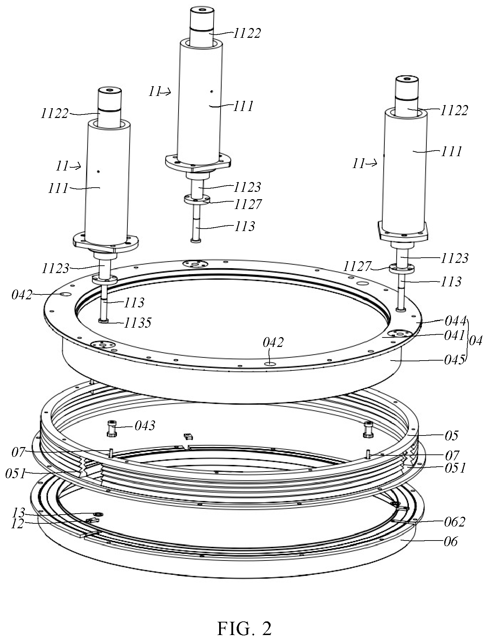

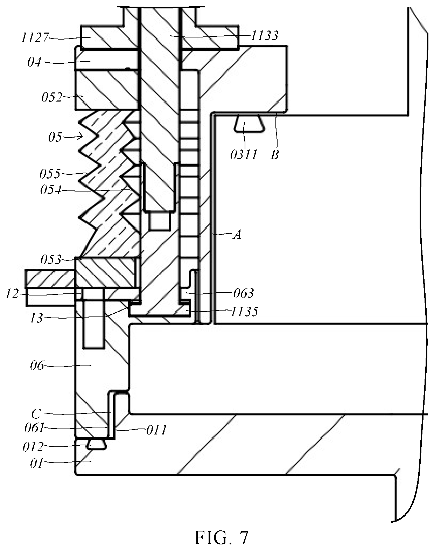

In some embodiments, as shown in FIGs. 2 and 7, the second annular liner 06 can be provided with a connection groove 062, and a hooking protrusion 063 is provided at the part of the connection groove 062 adjacent to the inner edge of the second annular liner 06.

Based on the annular liner apparatus disclosed in the embodiments of the present disclosure, the embodiments of the present disclosure further disclose a liner for a process chamber. The disclosed liner for the process chamber includes a third annular liner 01 and the annular liner apparatus provided in the above embodiments. The second annular liner 06 and the third annular liner 01 of the annular liner apparatus can be in pressing engagement. Specifically, the third annular liner 01 is the second component mentioned in the above embodiments.

To better achieve electrical connection, the liner of the process chamber disclosed in the present disclosure may further include a second induction coil 10. The second induction coil 10 extends circumferentially along the third annular liner 01 and is pressed between the second annular liner 06 and the third annular liner 01 in the process chamber in a process state, electrically connecting the second annular liner 06 and the third annular liner 01. The second induction coil 10 can better perform the electrical connection function, thereby better achieving the electrical connection between the second annular liner 06 and the third annular liner 01, thus optimizing the grounding connection and making it easier to form a good shielding structure.

To better position the second induction coil 10 between the second annular liner 06 and the third annular liner 01, further, in some embodiments, at least one of the third annular liner 01 or the second annular liner 06 may be provided with a second annular positioning groove 012. The second induction coil 10 can be positioned in the second annular positioning groove 012, thereby being positioned more stably between the second annular liner 06 and the third annular liner 01 by the positioning of the second annular positioning groove 012.

The annular end face of the bottom of the second annular liner 06 can be either a flat surface or a bent surface. Similarly, the edge of the third annular liner 01 can be either a flat surface or a bent surface; this embodiment does not impose any limitations. In some embodiments, the annular end face of the bottom of the second annular liner 06 can be a first bent surface 061, and the edge of the third annular liner 01 can be provided with a second bent surface 011. The shapes of the first bent surface 061 and the second bent surface 011 are adapted to each other, forming a bent third gap C. In this case, the third gap C is essentially a bent fitting gap, facilitates the formation of a labyrinth structure, ultimately making it more conducive to preventing plasma escape. Even if plasma enters, the plasma is more likely to be annihilated due to the long labyrinth structure, thus preventing plasma escape. The first bent surface 061 and the second bent surface 011 can both be concave and convex surfaces, for example.

Based on the liner disclosed consistent with the present disclosure, the present disclosure further discloses a process chamber. The disclosed process chamber includes a chamber 08, a carrier 02, and the liner provided in the above embodiment.

Chamber 08 is the main peripheral component of the process chamber. Chamber 08 not only provides a mounting base for other components of the process chamber but also forms some necessary structures for the process chamber. For example, chamber 08 has a wafer transfer port 081 for wafer passage. The liner and carrier 02 are both located within chamber 08, with the third annular liner 01 surrounding the carrier 02. The process chamber has a process state and a non-process state. The space above the carrier 02 is the process space D. The annular liner apparatus can be arranged around the process space D.

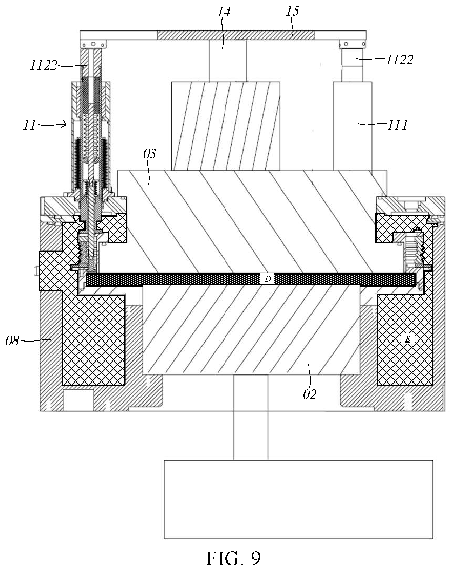

When the process chamber is in the process state, the second annular liner 06 presses against the third annular liner 01, thereby isolating the process space D from the wafer transfer port 081. The process space D can be effectively sealed to prevent plasma escape and also forms a shielding structure for shielding the process space D, as shown in FIG. 9. The process space D is the shaded area in FIG. 9. FIG. 9 shows that the process space D is isolated from other areas in the internal space E (as shown in the rhomboid-filled area in FIG. 9). It is readily understood that the first annular liner 04 is in a state of pressing against the first component (e.g., the distribution plate 03 described later). Specifically, the first annular liner 04 can press against the first component (e.g., the distribution plate 03 described later) by setting an annular edge 041.

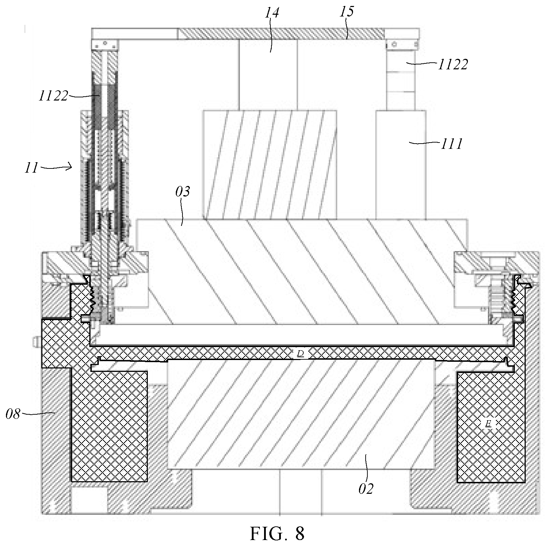

As shown in FIG. 8, when the process chamber is in a non-process state, the second annular liner 06 separates from the third annular liner 01, and the cylindrical liner 05 shortens and avoids the wafer transfer port 081. Specifically, the cylindrical liner 05 shortens and can form a connecting passage with the third annular liner 01. The connecting passage can connect the wafer transfer port 081 and the process space D, thereby enabling the wafer to be transported from the process space D through the wafer transfer port 081 or enter the process space D from the wafer transfer port 081. In this case, the process space D is connected to other areas of the internal space E, as shown by the rhomboid-filled area in FIG. 8.

In some embodiments, the process chamber disclosed in the present disclosure may further include a distribution plate 03 used to distribute process gases. A distribution plate 03 is disposed within the chamber 08, forming a process space D between the distribution plate 03 and the carrier 02. When the process chamber is in the process state, the first annular liner 04 is in a state of pressing against the first component (e.g., the distribution plate 03 described later). Specifically, the first annular liner 04 can press against the edge 031 of the distribution plate 03 by providing an annular edge 041.

When the process chamber includes the distribution plate 03, the chamber 08 may have a top opening, and the distribution plate 03 covers the top opening of the chamber 08, thereby ensuring that the edge 031 of the distribution plate 03, the third annular liner 01, the annular liner apparatus, and the carrier 02 are all located within the chamber 08. In this case, the distribution plate 03 not only functions to distribute process gases but also, together with the chamber 08, forms the outer perimeter of the process chamber.

To improve the electrical connection, the process chamber disclosed in the present disclosure may further include a first induction coil 09. In embodiments where an annular edge 041 is provided at the inner edge of the first annular liner 04, the first induction coil 09 is arranged circumferentially along the annular edge 041. When the process chamber is in the process state, the first induction coil 09 is pressed between the annular edge 041 of the first annular liner 04 and the edge 031 of the distribution plate 03. The first induction coil 09 can also effectively prevent plasma from escaping from the gap between the annular edge 041 and the edge of the distribution plate 03, while also improving the grounding connection.

Furthermore, at least one of the annular edge 041 or the distribution plate 03 may be provided with a first annular positioning groove 0311, and the first induction coil 09 can be positioned in the first annular positioning groove 0311. The positioning and cooperation between the first induction coil 09 and the first annular positioning groove 0311 ensure a relatively stable position for the first induction coil 09.

As described above, when the process chamber is in the process state, the first annular liner 04 is in a state of pressing against the distribution plate 03. Specifically, the first annular liner 04 can press against the edge 031 of the distribution plate 03 by providing an annular edge 041, and the second annular liner 06 presses against the third annular liner 01. To achieve this pressing, in some embodiments, the process chamber disclosed in the present disclosure may include a first driving mechanism and a second driving mechanism. The first driving mechanism is connected to the first annular liner 04 and is used to drive the first annular liner 04 (e.g., the annular edge 041of the first annular liner 04) to press against the edge 031 of the distribution plate 03. The second driving mechanism is connected to the second annular liner 06 and is used to drive the second annular liner 06 to press against the third annular liner 01. In this case, the pressing of the first annular liner 04 against the distribution plate 03 and the pressing of the second annular liner 06 against the third annular liner 01 can be achieved separately by the first driving mechanism and the second driving mechanism, respectively. The first driving mechanism and the second driving mechanism operate independently and do not affect each other.

Of course, in other embodiments disclosed in the present disclosure, the first annular liner 04 pressing against the distribution plate 03 and the second annular liner 06 pressing against the third annular liner 01 can share a common driving mechanism. Based on this, the present disclosure discloses a driving mechanism connected to the first annular liner 04 and the second annular liner 06 respectively. This driving mechanism can drive the first annular liner 04 to press against the distribution plate 03 and the second annular liner 06 to press against the third annular liner 01.

The driving mechanism disclosed in the present disclosure is connected to the first annular liner 04 and the second annular liner 06 respectively, and when the process chamber is in the process state, the driving mechanism drives the first annular liner 04 to move the annular edge 041 to press against the edge 031 of the distribution plate 03 and the second annular liner 06 to press against the third annular liner 01 respectively.

In some embodiments, the driving mechanism may include a pressing mechanism 11, the pressing mechanism 11 may include a first sliding member 112, a second sliding member 113, and an elastic member 114. The chamber 08 may have a through hole 082, through the through hole 082, the first sliding member 112 can pass and be connected to the first annular liner 04. The second sliding member 113 is partially slidably disposed within the first sliding member 112, and passes through the through hole 082 and is connected to the second annular liner 06. The elastic member 114 is connected between the first sliding member 112 and the second sliding member 113 and is in a pre-compressed state. When the driving mechanism performs the pressing drive, and the second annular liner 06 and the third annular liner 01 are only in contact, the first annular liner 04 (e.g., the annular edge 041) and the edge 031 of the distribution plate 03 are spaced apart in the pressing direction, that is, the first annular liner 04 (e.g., the annular edge 041) and the edge of the distribution plate 03 do not contact each other. In this configuration, the elastic member 114 can deform and be in a pre-compressed state, elastically connected between the first sliding member 112 and the second sliding member 113. This allows the drive mechanism to engage during the pressing action, with the second annular liner 06 and the third annular liner 01 contacting first. Then, as the pressing force increases, the second annular liner 06 presses against the third annular liner 01, while the first annular liner 04 (e.g., the annular edge 041) approaches and presses against the edge 031 of the distribution plate 03. Furthermore, the pre-compressed elastic member 114 further allows the first annular liner 04 (e.g., the annular edge 041) to press against the edge 031 of the distribution plate 03. This design, using the elastic member 114 as an elastic connection, allows the pressing between the second annular liner 06 and the third annular liner 01 and the pressing of the annular edge 041 against the edge 031 of the distribution plate 03 to occur sequentially, thus more easily achieving the purpose of individual pressing.

In a further technical solution, the pressing mechanism 11 may also include a cylindrical housing 111. The cylindrical housing 111 serves as an external component of the pressing mechanism 11, making it easier to provide an installation base and protection for other parts of the pressing mechanism 11. The cylindrical housing 111 is fixed outside the chamber 08, thereby enabling installation based on the chamber 08. The cylindrical housing 111 communicates with the internal space E of the chamber 08 through a through hole 082. At least a part of the first sliding member 112 is slidably disposed within the cylindrical housing 111. In this case, the first sliding member 112 can slidably pass through the through hole 082 with the cylindrical housing 111 as the sliding base, and then connect with the first annular liner 04 inside the chamber 08. Specifically, the first sliding member 112 and the first annular liner 04, as well as the cylindrical housing 111 and the chamber 08, can be fixed by connection using a connector (e.g., a threaded connector). To reduce particle generation, in some embodiments, the connectors located within the chamber 08 can be made of resin. Compared to metal connectors, which are more prone to generating metal particles and causing contamination, resin connectors are less likely to generate particles, thus reducing the risk of contamination of the internal environment of the chamber 08.

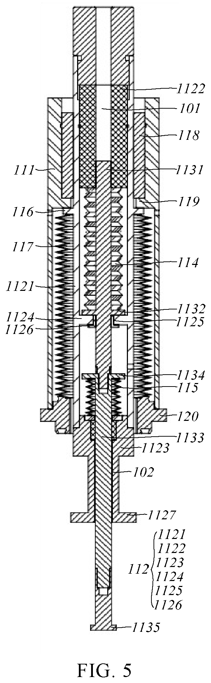

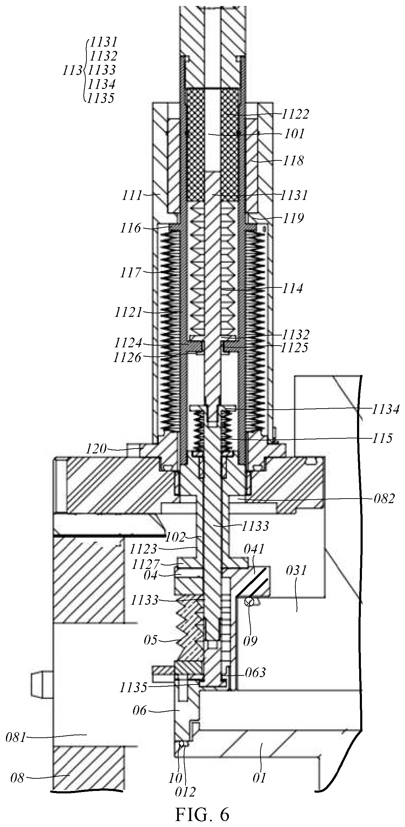

In the present disclosure, the structure of the first sliding member 112 can be varied. For example, the first sliding member 112 can be a common sliding rod. Referring again to FIGs. 5 and 6, in some embodiments, the first sliding member 112 can include a sliding cylinder 1121, a guide block 1122, and a connection block 1123.

The sliding cylinder 1121 is the main sliding part of the first sliding member 112, and at least part of the sliding cylinder 1121 is slidably disposed within the cylindrical housing 111. A connection block 1123 seals the port of the sliding cylinder 1121 adjacent to the chamber 08, and extends into the internal space E to connect with the first annular liner 04, thereby connecting the first sliding member 112 to the first annular liner 04. At least a part of the guide block 1122 is fixed within the sliding cylinder 1121. The guide block 1122 and the connection block 1123 are spaced apart; specifically, the guide block 1122 and the connection block 1123 are located at opposite ends of the sliding cylinder 1121. The connection block 1123 has a first guide hole 102, and the guide block 1122 has a second guide hole 101. The first guide hole 102 and the second guide hole 101 provide conditions for the sliding of the second sliding member 113. The first end of the second sliding member 113 is connected to the second annular liner 06. The second end of the second sliding member 113 passes through the first guide hole 102 and extends into the second guide hole 101, respectively slidingly engaging with both the first guide hole 102 and the second guide hole 101, thereby achieving the purpose of partially sliding the second sliding member 113 within the first sliding member 112.

In a further technical solution, the end of the connection block 1123 connected to the first annular liner 04 may be provided with a seventh annular flange 1127. Specifically, the seventh annular flange 1127 may be connected to the first annular liner 04. The seventh annular flange 1127 can provide a larger connection area, thereby facilitating the application of pressure from the connection block 1123 to the first annular liner 04, ultimately achieving a better pressing. In some embodiments, the seventh annular flange 1127 and the connection block 1123 may be a separate structure connected by assembly, or an integral structure, i.e., the seventh annular flange 1127 and the connection block 1123 are manufactured using a one-piece molding process.

The elastic member 114 is sleeved on the second sliding member 113 at the position between the first guide hole 102 and the second guide hole 101. The first end of the elastic member 114 is connected to the second sliding member 113; specifically, the first end of the elastic member 114 can be fixedly connected to the second sliding member 113 (e.g., by bonding, welding, etc.). The second end of the elastic member 114 abuts against the guide block 1122, such that the elastic member 114 is elastically connected between the first sliding member 112 and the second sliding member 113.

This structure not only enables the elastic member 114 to be elastically connected between the first sliding member 112 and the second sliding member 113, but also allows the first sliding member 112 to have a guiding space including a first guide hole 102 and a second guide hole 101, thereby achieving a sliding engagement between the second sliding member 113 and the first sliding member 112. Furthermore, by rationally designing the structure of the first sliding member 112, a space for accommodating the elastic member 114 is formed between the different components of the first sliding member 112, thus avoiding the elastic member 114 occupying excessive additional space and facilitating the compact design of the pressing mechanism.

In the embodiments of the present disclosure, the structure of the second sliding member 113 can be varied. The second sliding member 113 can be a common rod-shaped body. Of course, the structure of the second sliding member 113 can be designed to perform more functions. Based on this, in some embodiments, the second sliding member 113 may include a first rod body 1131 and a first annular flange 1132. The first annular flange 1132 is fixed to the first rod body 1131 and extends around the circumference of the first rod body 1131. The first rod body 1131 extends into the second guide hole 101 and is in sliding engagement with the second guide hole 101. The elastic member 114 is sleeved on the first rod body 1131, with the first end of the elastic member 114 elastically abutting against the first annular flange 1132. In this configuration, the first end of the elastic member 114, by abutting against the first annular flange 1132, achieves positioning along the axial direction of the second sliding member 113 (i.e., the sliding direction of the second sliding member 113). This allows the guide block 1122 to press the elastic member 114 when the first sliding member 112 slides, causing the elastic member 114 to contract between the guide block 1122 and the first annular flange 1132, thus accommodating the relative sliding between the first sliding member 112 and the second sliding member 113.

Consistent with the present disclosure, the elastic member 114 can be a helical spring, a bellows structure, or an elastic structure made of elastic material. This embodiment does not limit the specific type or structure of the elastic member 114.

In a further technical solution, the second sliding member 113 may include a second rod body 1133 and a second annular flange 1134. The second rod body 1133 can be connected to the first rod body 1131 by a threaded connection. The first end of the second rod body 1133 is located inside the sliding cylinder 1121, and the second end of the second rod body 1133 passes through the first guide hole 102 and is connected to the second annular liner 06. The second annular flange 1134 is located inside the sliding cylinder 1121. The pressing mechanism 11 disclosed in the present disclosure may also include a first telescopic cylinder 115. The first telescopic cylinder 115 is sleeved on the second rod body 1133, and the two ports of the first telescopic cylinder 115 are respectively sealed and connected to the second annular flange 1134 and the connection block 1123. In this configuration, after the second rod body 1133 extends into the chamber 08 through the first guide hole 102, the two ends of the first telescopic cylinder 115 are sealed and connected, thus the first guide hole 102 connects at most the cavity of the first telescopic cylinder 115 and the internal space E of the chamber 08. The first telescopic cylinder 115 then seals the first guide hole 102, preventing communication between the internal space E of the chamber 08 and the interior of the first sliding member 112, ultimately achieving a seal of the internal space E of the chamber 08 at the first guide hole 102.

In some embodiments, the first telescopic cylinder 115 can be a first bellows or other elastic sleeve structure. The present disclosure does not limit the specific type and structure of the first telescopic cylinder 115.

Consistent with the present disclosure, a third annular flange 1124 may also be provided inside the sliding cylinder 1121. The third annular flange 1124 forms a second mounting hole 1125. A first shaft sleeve 1126 is installed inside the second mounting hole 1125. The first shaft sleeve 1126 is located between the guide block 1122 and the connection block 1123. The second sliding member 113 passes through the first shaft sleeve 1126. The central axis of the first shaft sleeve 1126, the central axis of the first guide hole 102, and the central axis of the second guide hole 101 are collinear. Since the first shaft sleeve 1126, installed in the second mounting hole 1125, is located between the guide block 1122 and the connection block 1123, and the central axis of the first shaft sleeve 1126, the central axis of the first guide hole 102, and the central axis of the second guide hole 101 are collinear, the first shaft sleeve 1126 can assist in guiding between the guide block 1122 and the connection block 1123. This prevents the second sliding member 113 from bending at the portion between the guide block 1122 and the connection block 1123 due to excessive length and, thus making the sliding of the second sliding member 113 more stable. The first shaft sleeve 1126 can prevent direct wear on the third annular flange 1124. The first shaft sleeve 1126 is typically made of wear-resistant material.

Furthermore, the first shaft sleeve 1126 can be detachably installed in the second mounting hole 1125, and can be replaced when the first shaft sleeve 1126 is severely worn.

Since the first sliding member 112 also passes through the through hole 082 and extends into the internal space E of the chamber 08, connecting with the first annular liner 04, the pressing mechanism 11 disclosed in the present disclosure can also include a second telescopic cylinder 117 to ensure the sealing of the internal space E. The outer wall of the first sliding member 112 can be provided with a fourth annular flange 116. The second telescopic cylinder 117 can be sleeved on the first sliding member 112 and located inside the cylindrical housing 111. Both ends of the second telescopic cylinder 117 are respectively sealed and connected to the fourth annular flange 116 and the chamber 08. Specifically, the chamber 08 can include a mounting base 120 for mounting the cylindrical housing 111. The mounting base 120 has a through hole communicating with the through hole 082. Correspondingly, in this case, both ends of the second telescopic cylinder 117 are respectively sealed and connected to the fourth annular flange 116 and the outer surface (i.e., the surface facing away from the internal space E) of the mounting base 120.

Similarly, in some embodiments, the second telescopic cylinder 117 can be a second bellows or other elastic sleeve structures. The present disclosure does not limit the specific type and structure of the second telescopic cylinder 117.

To make the sliding of the first sliding member 112 within the cylindrical housing 111 more stable, the pressing mechanism 11 disclosed in the present disclosure may further include a second shaft sleeve 118 and a fifth annular flange 119 fixed within the cylindrical housing 111. The second shaft sleeve 118 is axially fixed to the fifth annular flange 119 and sleeved outside the first sliding member 112. The fifth annular flange 119 can prevent the second shaft sleeve 118 from sliding within the cylindrical housing 111, thereby positioning the second shaft sleeve 118 at a preset height within the cylindrical housing 111. The first sliding member 112 and the second shaft sleeve 118 are in a guiding sliding engagement in the sliding direction of the first sliding member 112. The second shaft sleeve 118 is essentially a linear bearing. The second shaft sleeve 118 enables the first sliding member 112 to slide more precisely within the cylindrical housing 111. Meanwhile, the second shaft sleeve 118 prevents the first sliding member 112 from directly abrading the cylindrical housing 111. In some embodiments, the second shaft sleeve 118 can be detachably installed within the cylindrical housing 111.

In the present disclosure, the connection between the second sliding member 113 and the second annular liner 06 of the pressing mechanism can be varied. For example, the second sliding member 113 and the second annular liner 06 can be connected by a threaded connection. Considering that threaded connections need multiple turns during assembly and disassembly, which can easily generate contaminating particles, in some embodiments, the second annular liner 06 can be provided with a connection groove 062, and an hooking protrusion 063 can be provided at the inner edge of the connection groove 062 near the second annular liner 06.

Under this premise, the pressing mechanism disclosed in the embodiments of the present disclosure may further include a clamping piece 12 detachably snapped onto the connection groove 062. The clamping piece 12 is opposite to the hooking protrusion 063, and the clamping piece 12 and the hooking protrusion 063 form a clearance hole. The end of the second sliding member 113 is provided with a sixth annular flange 1135, and the sixth annular flange 1135 is located in the connection groove 062. Other parts of the second sliding member 113 extend out of the connection groove 062 from the clearance hole. The sixth annular flange 1135 is in hooked engagement with the clamping piece 12 and the hooking protrusion 063 respectively. During installation, the end of the second sliding member 113 can be first placed into the connection groove 062, and then the clamping piece 12 can be snapped onto the connection groove 062. This creates a clearance hole between the clamping piece 12 and the hooking protrusion 063, ultimately achieving simultaneous engagement between the sixth annular flange 1135 of the second sliding member 113 and both the clamping piece 12 and the hooking protrusion 063. The second sliding member 113 then moves the second annular liner 06 through the engagement. During disassembly, the operator only needs to remove the clamping piece 12 to disengage the sixth annular flange 1135 of the second sliding member 113 from the connection groove 062, thus separating the second sliding member 113 from the second annular liner 06. This assembly method allows for direct connection through the snap-fit, reducing particle contaminant generation compared to threaded connections which need prolonged twisting.

In a further technical solution, the pressing mechanism 11 disclosed in the present disclosure may further include a washer 13, the washer 13 may be disposed between the sixth annular flange 1135, the clamping piece 12, and the hooking protrusion 063. The washer 13 can fill the gap, thereby improving the stability of the connection between the second sliding member 113 and the second annular liner 06, and preventing the sixth annular flange 1135 from loosening in the connection groove 062 and easily causing collisions, thus preventing the generation of particulate matter from collisions.

When the first annular liner 04 includes a liner cylinder 045, the cylindrical liner 05 may have a clearance window 051 serving a clearance function. The clearance window 051 facilitates the operator's hook-fitting operation of the second sliding member 113 and the installation of the washer 13 and clamping piece 12. Of course, in this case, the liner cylinder 045 is located inside the clearance window 051, thus preventing plasma in the process space D surrounded by the liner from leaking through the clearance window 051.

In the process chamber disclosed in the present disclosure, the driving mechanism may further include a power source 14. The end of the first sliding member 112 may extend out of the port of the cylindrical housing 111 away from the chamber 08 and be connected to the power source 14. The power source 14 can drive the first sliding member 112 to slide, and the first sliding member 112 drives the second sliding member 113 to slide via the elastic member 114.

In a further optional embodiment, there may be multiple pressing mechanisms 11 spaced apart to achieve relatively balanced pressing. In some embodiments, there may be multiple power sources 14, each corresponding to one of the multiple pressing mechanisms 11. Of course, in other embodiments, the power source 14 may be connected to the first sliding members 112 of the multiple pressing mechanisms 11 to drive the first sliding members 112 of the multiple pressing mechanisms 11 to slide.

In the present disclosure, the power source 14 may be a telescopic mechanism or other structures; the present disclosure does not limit the specific type of power source 14. To drive multiple pressing mechanisms 11, in some embodiments, the driving mechanism may further include a connection rod 15. The telescopic mechanism is fixed to the distribution plate 03, and the telescopic end of the telescopic mechanism is connected to the first sliding member 112 via the connection rod 15. The telescopic mechanism can drive the first sliding members 112 of multiple pressing mechanisms 11 to slide synchronously via the connection rod 15. In this case, the power source 14 can simultaneously drive the first sliding members 112 of multiple pressing mechanisms 11 via the connection rod 15, thereby achieving the goal of driving more first sliding members 112 and second sliding members 113 to slide with small number of power sources 14. This undoubtedly helps to simplify the structure of the process chamber.

As described above, the first annular liner 04 may include an annular body 044 and a liner cylinder 045. In an embodiment where the inner edge of the annular body 044 includes an annular edge 041, the first port of the liner cylinder 045 is sealed to the surface of the annular body 044 facing towards the second annular liner 06, and the second port of the liner cylinder 045 is disposed adjacent to the second annular liner 06. At least a part of the liner cylinder 045 is disposed inside the cylindrical liner 05.

Based on this, further, the gap formed between the inner wall of the liner cylinder 045 and the opposite part of the distribution plate 03 can be a first gap A, and the gap formed between the annular edge 041 and the edge 031 of the distribution plate 03 can be a second gap B. The first gap A and the second gap B may intersect. Specifically, the first gap A may be perpendicular to the second gap B. Since the first gap A intersects with the second gap B, a labyrinth structure can be formed between the first annular liner 04 and the distribution plate 03. This effectively prevents plasma from escaping from the process space D. Furthermore, even if plasma does enter, the plasma is easily annihilated due to the relatively long labyrinth structure, thus preventing plasma from escaping.

Based on the process chamber provided in the embodiments of the present disclosure, the embodiments of the present disclosure further provide semiconductor process equipment, and the semiconductor process equipment includes the process chamber provided in the above embodiments.

The above embodiments of the present disclosure focus on describing the differences between various embodiments. Different optimized features of various embodiments can be combined to form better embodiments as long as they are not contradictory, and they will not be elaborated further here for brevity.

The embodiments of the present disclosure have been described above with reference to the accompanying drawings. However, the present disclosure is not limited to the specific embodiments described above. The specific embodiments described above are merely illustrative and not restrictive. Those skilled in the art, under the guidance of the present disclosure, can make many forms without departing from the spirit and scope of the claims, all of which fall within the protection scope of the present disclosure.

## Claims

1. An annular liner apparatus for a process chamber, comprising a first annular liner, a cylindrical liner, and a second annular liner, wherein:
the first annular liner is connected to a first end of the cylindrical liner, and the second annular liner is connected to a second end of the cylindrical liner, the cylindrical liner being expandable and retractable in an axial direction of the cylindrical liner.

2. The annular liner apparatus according to claim 1, further comprising a guide rod, a first end of the guide rod being fixedly connected to one of the first annular liner and the second annular liner, a second end of the guide rod passing through a side wall of the cylindrical liner and at least extending through another of the first annular liner and the second annular liner, the guide rod slidingly engaging with the first annular liner or the second annular liner and serving to guide the alignment of the first annular liner and the second annular liner.

3. The annular liner apparatus according to claim 2, wherein the first annular liner or the second annular liner is provided with a first mounting hole, a first sleeve being fixedly installed in the first mounting hole, the guide rod extending through the first sleeve and slidingly engaging with the first sleeve.

4. The annular liner apparatus according to claim 2, wherein there are a plurality of guide rods, and the plurality of guide rods are spaced apart in a circumferential direction of the annular liner apparatus.

5. The annular liner apparatus according to claim 1, wherein an inner edge of the first annular liner protrudes from an inner wall of the cylindrical liner and forms an annular edge.

6. The annular liner apparatus according to claim 5, wherein the first annular liner includes an annular body and a liner cylinder, an inner edge of the annular body includes the annular edge, a first port of the liner cylinder is sealingly connected to a surface of the annular body facing towards the second annular liner, a second port of the liner cylinder is disposed adjacent to the second annular liner, and at least a part of the liner cylinder is disposed inside the cylindrical liner.

7. The annular liner apparatus according to claim 5, wherein a first annular positioning groove is formed at a surface of the annular edge facing towards the second annular liner, and/or, a second annular positioning groove is formed at an edge of the second annular liner.

8. The annular liner apparatus according to claim 1, wherein the second annular liner is provided with a connection groove, and a hooking protrusion is provided at a part of the connection groove adjacent to an inner edge of the second annular liner.

9. The annular liner apparatus according to any one of claims 1-8, wherein the cylindrical liner includes a first ring, a second ring, an inner bellows, and an outer bellows, the inner bellows being disposed within the outer bellows and forming an annular gap between the inner bellows and the outer bellows, the first ring being sealed at a first end of the annular gap, the second ring being sealed at a second end of the annular gap, the first ring being connected to one of the first annular liner and the second annular liner, and the second ring being connected to another of the first annular liner and the second annular liner.

10. The annular liner apparatus according to claim 9, further comprising a guide rod, a part of the guide rod being located in the annular gap, one end of the guide rod passing through the second ring and being fixedly connected to one of the first annular liner and the second annular liner, another end of the guide rod passing through the first ring and being slidably engaged with another of the first annular liner and the second annular liner.

11. A liner for a process chamber, comprising a third annular liner and the annular liner apparatus according to any one of claims 1 to 10, wherein the second annular liner can be in pressing engagement with the third annular liner of the annular liner apparatus.

12. The liner according to claim 11, further comprising a second induction coil, the second induction coil extending circumferentially along the third annular liner and being pressed between the second annular liner and the third annular liner in the process chamber in a process state, and electrically connecting the second annular liner and the third annular liner.

13. The liner according to claim 12, wherein at least one of the third annular liner or the second annular liner is provided with a second annular positioning groove, and the second induction coil is positioned in the second annular positioning groove.

14. The liner according to claim 11, wherein an annular end face of a bottom end of the second annular liner is a first bent surface, an edge of the third annular liner is provided with a second bent surface, shapes of the first bent surface and the second bent surface are adapted to each other, and the first bent surface and the second bent surface form a bent third gap.

15. A process chamber comprising a chamber, a carrier, and a liner according to any one of claims 11 to 14, wherein the chamber has a transfer port, and the third annular liner is disposed around the carrier;
in a process state, the second annular liner presses against the third annular liner;
in a non-process state, the second annular liner separates from the third annular liner, and the cylindrical liner shortens and avoids the transfer port.

16. The process chamber according to claim 15, further comprising a distribution plate, the distribution plate covering a top opening of the chamber, and an edge of the distribution plate, the third annular liner, the annular liner apparatus, and the carrier are all disposed within the chamber.

17. The process chamber according to claim 16, wherein an inner edge of the first annular liner protrudes from an inner wall of the cylindrical liner and forms an annular edge; the process chamber further includes a first induction coil, the first induction coil being arranged circumferentially along the annular edge and pressed between the annular edge and the edge of the distribution plate in the process state, and electrically connecting the first annular liner and the distribution plate.

18. The process chamber according to claim 17, wherein at least one of the annular edge or the edge of the distribution plate is provided with a first annular positioning groove, the first induction coil being positioned in the first annular positioning groove.

19. The process chamber according to claim 16, further comprising a driving mechanism, the driving mechanism being connected to the first annular liner and the second annular liner respectively, and configured to drive the first annular liner in the process state to cause the annular edge to press against the edge of the distribution plate and the second annular liner to press against the third annular liner respectively.

20. The process chamber according to claim 19, wherein an inner edge of the first annular liner protrudes from an inner wall of the cylindrical liner, forming an annular edge; the driving mechanism includes a pressing mechanism, the pressing mechanism including a first sliding member, a second sliding member, and an elastic member; the chamber is provided with a through hole, the first sliding member passes through the through hole and is connected to the first annular liner, a part of the second sliding member is slidably disposed within the first sliding member, and passes through the through hole and is connected to the second annular liner; the elastic member is connected between the first sliding member and the second sliding member, and is in a pre-compressed state; when the driving mechanism performs pressing drive, with the second annular liner only in contact with the third annular liner, the annular edge and the edge of the distribution plate are spaced apart in a pressing direction.

21. The process chamber according to claim 20, wherein the pressing mechanism further includes a cylindrical housing, the cylindrical housing being fixed outside the chamber, and communicating with an internal space of the chamber through the through hole, and at least a part of the first sliding member being slidably disposed within the cylindrical housing.

22. The process chamber according to claim 21, wherein the first sliding member includes a sliding cylinder, a guide block, and a connection block, wherein:
at least a part of the sliding cylinder is slidably disposed within the cylindrical housing, the connection block seals a port of the sliding cylinder adjacent to the chamber and extends into the internal space to be connected to the first annular liner, at least a part of the guide block is fixed within the sliding cylinder and spaced apart from the connection block, the connection block has a first guide hole, and the guide block has a second guide hole;
a first end of the second sliding member is connected to the second annular liner, a second end of the second sliding member passes through the first guide hole and extends into the second guide hole, respectively slidingly engaging with the first guide hole and the second guide hole, the elastic member is sleeved on a part of the second sliding member located between the first guide hole and the second guide hole, a first end of the elastic member is connected to the second sliding member, and a second end of the elastic member abuts against the guide block.

23. The process chamber according to claim 22, wherein the second sliding member comprises a first rod body and a first annular flange, the first annular flange being fixed to the first rod body and extending circumferentially around the first rod body, the first rod body extending into the second guide hole and slidingly engaging with the second guide hole, the elastic member being sleeved on the first rod body, and the first end of the elastic member elastically abutting against the first annular flange.

24. The process chamber according to claim 22, wherein the second sliding member includes a second rod body and a second annular flange, a first end of the second rod body being located inside the sliding cylinder, a second end of the second rod body passing through the first guide hole and connected to the second annular liner, the second annular flange being located inside the sliding cylinder, the pressing mechanism further including a first telescopic cylinder, the first telescopic cylinder being sleeved on the second rod body, and two ports of the first telescopic cylinder being respectively sealed and connected to the second annular flange and the connection block.

25. The process chamber according to claim 22, wherein a third annular flange is provided inside the sliding cylinder, the third annular flange forms a second mounting hole, a first shaft sleeve is installed in the second mounting hole, the first shaft sleeve is located between the guide block and the connection block, the second sliding member passes through the first shaft sleeve, and a central axis of the first shaft sleeve, a central axis of the first guide hole, and a central axis of the second guide hole are collinear.

26. The process chamber according to claim 21, wherein a fourth annular flange is provided at an outer wall of the first sliding member, the pressing mechanism further includes a second telescopic cylinder, the second telescopic cylinder is sleeved on the first sliding member and located inside the cylindrical housing, and two ends of the second telescopic cylinder are respectively sealed and connected to the fourth annular flange and the chamber.

27. The process chamber according to claim 21, wherein the pressing mechanism further includes a second shaft sleeve and a fifth annular flange fixed inside the cylindrical housing, the second shaft sleeve is fixed to the fifth annular flange along an axial direction and sleeved outside the first sliding member, the first sliding member and the second shaft sleeve are guided and slidably engaged in a sliding direction of the first sliding member.

28. The process chamber according to claim 21, wherein the second annular liner is provided with a connection groove, and a hooking protrusion is provided at a part of the connection groove adjacent to an inner edge of the second annular liner;
the pressing mechanism further includes a clamping piece, the clamping piece being detachably snapped onto the connection groove, the clamping piece facing towards the hooking protrusion, the clamping piece and the hooking protrusion forming a clearance hole, an end of the second sliding member being provided with a sixth annular flange, the sixth annular flange being located within the connection groove, other parts of the second sliding member extending out of the connection groove from the clearance hole, the sixth annular flange being in hooked engagement with the clamping piece and the hooking protrusion respectively.

29. The process chamber according to claim 28, wherein the pressing mechanism further includes a washer, the washer being disposed between the sixth annular flange and the clamping piece, and between the sixth annular flange and the hooking protrusion.

30. The process chamber according to claim 21, wherein an end of the first sliding member extends beyond a port of the cylindrical housing away from the chamber, the driving mechanism further includes a power source, and there are a plurality of pressing mechanisms spaced apart, the power source being connected to first sliding members of the plurality of pressing mechanisms to drive the first sliding members to slide.

31. The process chamber according to claim 30, wherein the power source is a telescopic mechanism, the driving mechanism further includes a connection rod, the telescopic mechanism is fixed to the distribution plate, and a telescopic end of the telescopic mechanism is connected to the first sliding member through the connection rod, the telescopic mechanism can drive the first sliding members of the plurality of pressing mechanisms to slide synchronously through the connection rod.

32. The process chamber according to claim 16, wherein the first annular liner comprises an annular body and a liner cylinder, an inner edge of the annular body protruding from an inner wall of the liner cylinder and forming an annular edge; a first port of the liner cylinder is sealingly connected to a surface of the annular body facing towards the second annular liner, a second port of the liner cylinder is disposed adjacent to the second annular liner, and at least a part of the liner cylinder is disposed inside the cylindrical liner;
a gap formed between the inner wall of the liner cylinder and the distribution plate is a first gap, a gap formed between the annular edge and the edge of the distribution plate is a second gap, and the first gap intersects with the second gap.

33. Semiconductor process equipment comprising the process chamber according to any one of claims 15 to 32.
